Europäisches Patentamt

European Patent Office

Office européen des brevets

(11) Veröffentlichungsnummer: **0 578 261 A1**

## (12) EUROPÄISCHE PATENTANMELDUNG

(21) Anmeldenummer: **93111042.3**

(22) Anmeldetag: **09.07.93**

(51) Int. Cl.5: **H03K 17/95**

(30) Priorität: **09.07.92 DE 4222616**
**21.08.92 DE 4227831**
**10.11.92 DE 4237929**

(43) Veröffentlichungstag der Anmeldung:
**12.01.94 Patentblatt 94/02**

(84) Benannte Vertragsstaaten:
**AT BE CH DE DK ES FR GB GR IE IT LI LU MC
NL PT SE**

(71) Anmelder: **SIEMENS AKTIENGESELLSCHAFT**
**Wittelsbacherplatz 2**
**D-80333 München(DE)**

(72) Erfinder: **Jansseune, Luc**
**Arno-Assmann-Strasse 11**
**D-81739 München(DE)**

(54) **Näherungsschalter mit einem Magnetfeld-Sensor.**

(57) Der Näherungsschalter enthält einen zweipoligen Dauermagneten (1), an dessen Längsseite in der neutralen Zone (1a) zwischen beiden Polen ein Magnetfeld-Sensor (2) angeordnet ist. Durch Annäherung eines ferromagnetischen Auslösekörpers (4) an einen der Pole wird die mit dem Magnetfeld-Sensor (2) verbundene Auswerteschaltung (3) ausgelöst. Mit Hilfe eines zweiten Magnetfeld-Sensors in diametral gegenüberliegender Anordnung zu dem ersten kann zusätzlich die Annäherungsrichtung erkannt werden.

Mit dieser Anordnung erhält man einen sehr kleinen und mit wenigen einfachen Teilen aufgebauten Näherungsschalter.

FIG 1

Die Erfindung betrifft einen Näherungsschalter mit einem Magnetfeld-Sensor, welcher in fester räumlicher Beziehung zu einem zweipoligen Dauermagneten angeordnet und mit einer Schalteinrichtung verbunden ist, wobei durch Annäherung eines Auslösekörpers an den Dauermagneten die magnetische Induktion am Magnetfeld-Sensor veränderbar und zu einer Änderung des Schaltzustandes der Schalteinrichtung auswertbar ist.

Aus der US-PS 4 295 118 ist eine Schalteinrichtung bekannt, bei der ein Hall-Sensor auf einem Pol eines Dauermagneten angeordnet ist. Um den Schalter zu betätigen, ist dort ein zweiter, beweglicher Dauermagnet oder ein wahlweise erregbarer Elektromagnet vorgesehen, der das Feld des erstgenannten Magneten umpolt und durch die Induktionsänderung am Hall-Sensor die Schalteinrichtung auslöst. Die Verwendung des zweiten Magneten macht diese bekannte Einrichtung allerdings verhältnismäßig aufwendig, zumal bei der Verwendung als Näherungsschalter der zweite Magnet auf einem beweglichen Teil angeordnet sein müßte.

Aus der US-PS 5 045 920 ist weiterhin ein Annäherungsschalter mit einem Hall-Differenz-Schaltkreis bekannt, bei dem zwei Hall-Sensoren in einem bestimmten Abstand voneinander angeordnet sind und die Schaltbedingung durch das Auftreten oder Verschwinden einer vorgegebenen Differenz der magnetischen Induktion an beiden Sensoren gegeben ist. Die Auslösung kann in diesem Fall durch einen ferromagnetischen Auslösekörper erfolgen. Allerdings ist die Schaltanordnung insofern aufwendig, als zwei Hall-Sensoren mit gleichen Kennwerten verwendet werden müssen, deren Abgleich auf eine Nulldifferenz als Ausgangspunkt zusätzlichen Justieraufwand erfordert.

Aufgabe der vorliegenden Erfindung ist es, einen Näherungsschalter mit wenigen einfachen Bauteilen zu schaffen, der kostengünstig ist, wenig Platz beansprucht und für die Schaltfunktion mit einem einzigen Magnetfeld-Sensor auskommt.

Erfindungsgemäß wird diese Aufgabe dadurch gelöst, daß der Magnetfeld-Sensor seitlich nahe dem, insbesondere an dem Dauermagneten in der Nähe der neutralen Zone zwischen beiden Polen des Dauermagneten positioniert ist und daß durch Annäherung eines ferromagnetischen Auslösekörpers beziehungsweise durch Entfernung des Auslösekörpers von dem Dauermagneten jeweils eine zur Umschaltung der Schalteinrichtung auswertbare Änderung der magnetischen Induktion an dem Magnetfeld-Sensor erzeugt wird.

Die Aufgabe wird auch dadurch gelöst, daß der Magnetfeld-Sensor seitlich nahe dem, insbesondere an dem Dauermagneten parallel zur Tangente der Flußlinien des Dauermagneten positioniert ist und daß durch Annäherung eines ferromagnetischen Auslösekörpers beziehungsweise durch Entfernung des Auslösekörpers von dem Dauermagneten jeweils eine zur Umschaltung der Schalteinrichtung auswertbare Änderung der magnetischen Induktion an dem Magnetfeld-Sensor erzeugt wird.

Der erfindungsgemäße Näherungsschalter benötigt also lediglich einen einzigen Dauermagneten und einen einzigen Magnetfeld-Sensor. Der letztere ist nicht, wie sonst üblich, auf einer Polfläche des Dauermagneten angeordnet, sondern seitlich an diesem und mehr oder weniger im neutralen Bereich zwischen beiden Polen. Der Schaltbereich an einer Polfläche, der von dem ferromagnetischen Auslösekörper eingenommen wird, ist somit unabhängig von der Anordnung des Magnetfeld-Sensors. Die aktive Fläche an dem Pol kann dabei vollständig von dem Auslöseteil überdeckt werden, ohne daß dadurch der Schaltbereich beeinflußt wird. Bei seitlicher Montage auf einer ferromagnetischen Platte ist kaum eine Änderung des Schaltbereiches wahrzunehmen. Bei dieser Anordnung von Dauermagnet und Magnetfeld-Sensor ist auch sichergestellt, daß der Schalter nicht in unerwünschter Weise durch kleine Objekte, beispielsweise durch Späne, ausgelöst wird. Die Toleranzen und die Temperaturdrift sind hierbei ebenfalls geringer als bei Schaltern mit Magnetfeld-Differenzmessungen. Der Schalter kann im übrigen als Öffner oder als Schließer ausgeführt sein. Bei Verwendung eines bistabilen Magnetfeld-Sensors ist es im übrigen möglich, durch Annäherung eines Auslösekörpers an einen Pol den Schalter einzuschalten und durch Annäherung an den anderen Pol ihn wieder auszuschalten.

Der Magnetfeld-Sensor wird zweckmäßigerweise in Form eines handelsüblichen integrierten Schaltkreises verwendet, der bereits die Auswerteschaltung enthält. Dieser IC oder Magnetfeld-Chip kann bei der Anordnung seitlich am Dauermagneten entweder genau auf die neutrale Zone eingestellt oder auch etwas gegenüber dieser neutralen Zone versetzt positioniert werden. Dadurch kann die magnetische Induktion im Ruhezustand entweder auf Null oder auf einen vorgegebenen Wert eingestellt werden, um für den Auslösezustand die magnetische Induktion in einem Bereich zu erhalten, in welchem entsprechend den Kennwerten des Magnetfeld-IC's dessen Schwellenwerte für das Einschalten und für das Ausschalten liegen.

Die Justierung kann im übrigen nicht nur durch mechanisches Verschieben zwischen Magnet und Magnetfeld-Sensor, sondern auch durch magnetischen Abgleich des Dauermagneten, also durch Änderung der Stärke oder der Richtung des Magnetvektors, erreicht werden.

Obwohl für die Funktion als Näherungsschalter ein einziger Magnetfeld-Sensor genügt, kann in einer Weiterbildung der Erfindung vorgesehen werden, daß ein zweiter Magnetfeld-Sensor dem erstgenannten diametral gegenüberliegend seitlich an dem Dauermagneten angeordnet wird. In diesem Fall kann aus der zeitlichen Folge der von beiden Sensoren abgegebenen Signale die Annäherungsrichtung des Auslösekörpers erkannt werden. Der Näherungsschalter dient in diesem Fall also auch zur Richtungserkennung und stellt fest, ob ein Objekt sich beispielsweise von links oder von rechts nähert.

Als Magnetfeld-Sensor kann je nach den Anwendungsbedingungen ein Hall-Sensor oder ein Magnetoresistor (eine Feldplatte) Verwendung finden. Auch andere magnetfeldempfindliche Elemente, wie Magnetfelddioden und dergleichen sind denkbar.

Die Erfindung wird nachfolgend an einem Ausführungsbeispiel anhand der Zeichnung näher erläutert. Es zeigen

Figur 1 eine Prinzipanordnung eines Dauermagneten mit einem Magnetfeld-IC und einem Auslösekörper,

Figur 2 einen idealisierten Verlauf der magnetischen Induktion seitlich vom Magneten ohne Auslösekörper und mit einem ferromagnetischen Auslösekörper,

Figur 3 den Verlauf der magnetischen Induktion an einem feststehenden Magnetfeld-Sensor in Abhängigkeit vom Abstand eines ferromagnetischen Auslösekörpers,

Figur 4 den Aufbau eines erfindungsgemäßen Näherungsschalters in einem Gehäuse,

Figur 5 den funktionellen Aufbau eines bei dem Näherungsschalter verwendeten Magnetfeld-IC's,

Figur 6 eine Prinzipanordnung eines Näherungsschalters zur Richtungsbestimmung mit zwei Magnetfeld-Sensoren und

Figur 7 den prinzipiellen Signalverlauf an den Ausgängen der beiden Magnetfeldsensoren von Figur 6.

Figur 8 bis 13 weitere erfindungsgemäße Anordnungen eines Dauermagneten mit einem Magnetfeld-IC und einem Auslösekörper.

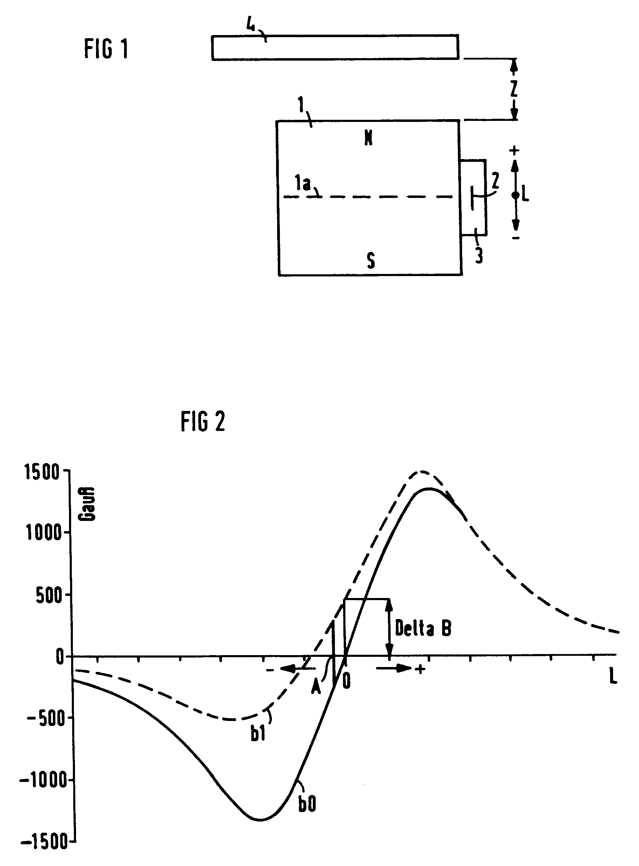

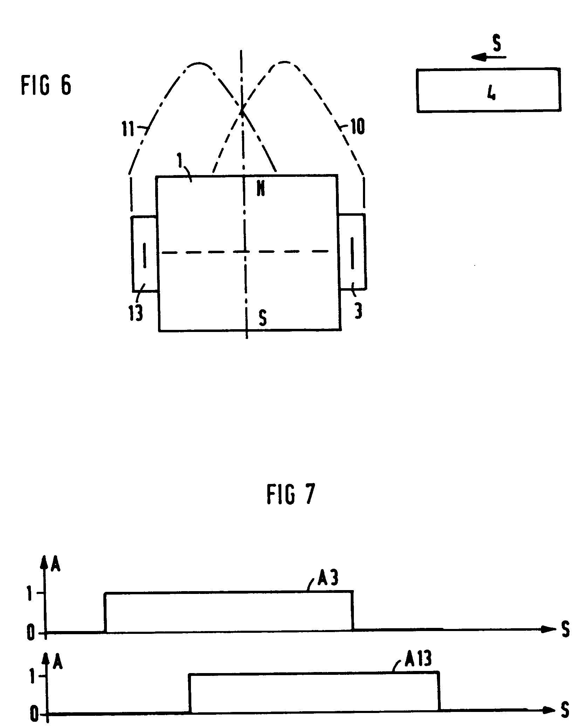

Die Figur 1 zeigt schematisiert die Anordnung der wesentlichen Bauteile für einen Magnetfeld-Näherungsschalter. An einem zweipoligen Dauermagneten 1 mit rundem, wahlweise auch eckigem Querschnitt, ist seitlich ein Magnetfeld-Sensor 2, beispielsweise ein Hall-Sensor angeordnet, der zusammen mit einer Auswerteschaltung in einem Magnetfeld-IC 3 enthalten ist. Ein solcher Magnetfeld-IC ist handelsüblich. Der grundsätzliche Aufbau mit einem Funktionsbild ist in Figur 5 gezeigt. In der Regel besitzt der IC drei Anschlüsse, einen Versorgungsanschluß 31, einen Masseanschluß 32 und einen Signalausgang 33. Im Inneren ist dem Magnetfeld-Sensor 2 eine Schwellenwertschaltung (Schmitt-Trigger) 21 mit Hysterese-Charakteristik und ein Halbleiterschalter 22 nachgeschaltet. Erreicht die magnetische Induktion am Magnetfeld-Sensor 2 den jeweiligen Schwellenwert des Schwellenwertschalters 21, wird der Halbleiterschalter 22 durchgeschaltet oder gesperrt.

Der Magnetfeld-IC 3 kann am Dauermagneten 1 so angeordnet werden, daß der Magnetfeld-Sensor 2 genau in der neutralen Zone zwischen beiden Polen liegt, welche durch die gestrichelte Linie 1a angedeutet ist. Dann wirkt am Magnetfeld-Sensor im Ruhezustand keine magnetische Induktion. Der Magnetfeld-IC kann aber auch je nach den Umständen in der Richtung L nach " + " oder "-" verschoben werden, so daß bereits im Ruhezustand eine bestimmte magnetische Induktion am Magnetfeld-Sensor anliegt. Wie sich diese Verschiebung in der Richtung L auswirkt, ist anhand des Induktionsverlaufs in Figur 2 zu sehen. Die durchgezogene Kurve b0 zeigt den Verlauf der Induktion an der Außenseite des Dauermagneten, solange kein Auslösekörper in der Nähe ist. Befindet sich der Magnetfeld-Sensor 2 genau in der neutralen Zone 1a, so ist die Induktion gleich Null. Je nach Verschiebung in Richtung + L oder - L ergibt sich der dargestellte Kurvenverlauf einer positiven oder negativen Induktion mit einem Maximum jeweils im Bereich der Pole. Nähert man nun einen ferromagnetischen Auslösekörper 4 (Figur 1) an einen Pol des Dauermagneten an, so verschiebt sich der Verlauf der magnetischen Induktion im Sinne der in Figur 2 gestrichelt gezeichneten Kurve b1. Wenn der Magnetfeld-Sensor 2 sich im Nullpunkt, also in der neutralen Zone befindet, so ist bei Annäherung des Auslösekörpers 4 in einer vorgegebenen Position nunmehr am Magnetfeld-Sensor eine magnetische Induktion B meßbar, die gemäß Figur 2 einen Wert von Delta B besitzt. Liegt dieser Wert von Delta B über dem Schwellenwert des Magnetfeld-IC's 3, so wird der Näherungsschalter umgeschaltet bzw. ausgelöst.

Es ist aber auch möglich, den Magnetfeld-Sensor nicht exakt in die neutrale Zone zu positionieren, sondern beispielsweise auf den Punkt A (Figur 2). In diesem Fall liegt im Ruhezustand bereits eine negative Induktion B an ihm an, während bei Annäherung des Auslösekörpers 4 ein bestimmter positiver Induktionswert erreicht wird. Auf diese Weise läßt sich der Magnetfeld-Sensor so einjustieren, daß bei Annäherung des Auslösekörpers jeweils gerade die Schwellenwerte (mit Hysterese) für das Umschalten des Magnetfeld-IC's erreicht werden.

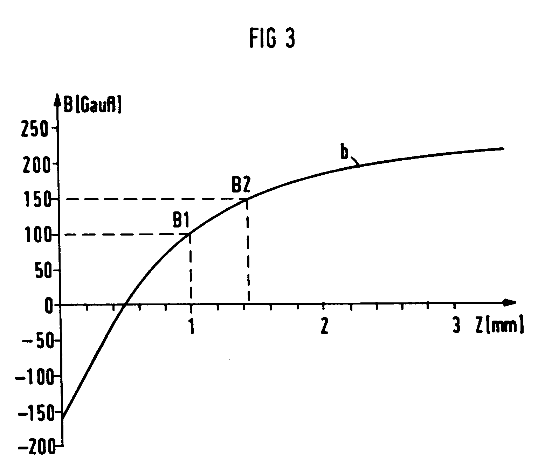

Figur 3 zeigt in einem weiteren Diagramm einen möglichen Verlauf der magnetischen Induktion B bei einem fest positionierten Magnetfeld-Sensor in Abhängigkeit von der Annäherung des Auslösekörpers 4. Auf der waagrechten Achse ist der Abstand z in Figur 1 zwischen dem Auslösekörper 4 und dem Nordpol des Dauermagneten 1 aufgetragen. Darüber zeigt die Kurve b den Verlauf der magnetischen Induktion B. Man erkennt, daß der Magnetfeld-Sensor sich nicht genau in der neutralen Zone befindet. Denn bei Entfernung des Auslösekörpers wird die Induktion nicht zu Null, sondern nähert sich an einen Wert von etwa 200 G an. Bei stärkerer Annäherung des Auslösekörpers an den Pol (weniger als 2 mm) verringert sich die magnetische Induktion, geht bei etwa 0,5 mm durch die Nullachse und wird dann negativ. Bei dem gezeigten Beispiel mit den lediglich für ganz bestimmte Verhältnisse gültigen Zahlen wird angenommen, daß die Schaltschwellen des Magnetfeld-IC's 3 für das Einschalten (B1) und für das Ausschalten (B2) die folgenden Werte annehmen:

$B1 = 100\ G$
$B2 = 150\ G.$

Entsprechend schaltet der Magnetfeld-IC ein, wenn der Abstand z des Auslösekörpers vom Dauermagneten 1 mm beträgt, und er schaltet aus, wenn der Abstand z etwa 1,4 mm beträgt. Es sei betont, daß diese Werte natürlich nur für ganz bestimmte Verhältnisse und für einen bestimmten Schaltkreis gelten. Je nach den verwendeten Bauteilen werden natürlich auch die Schaltschwellen andere Werte der Induktion und des Abstandes aufweisen.

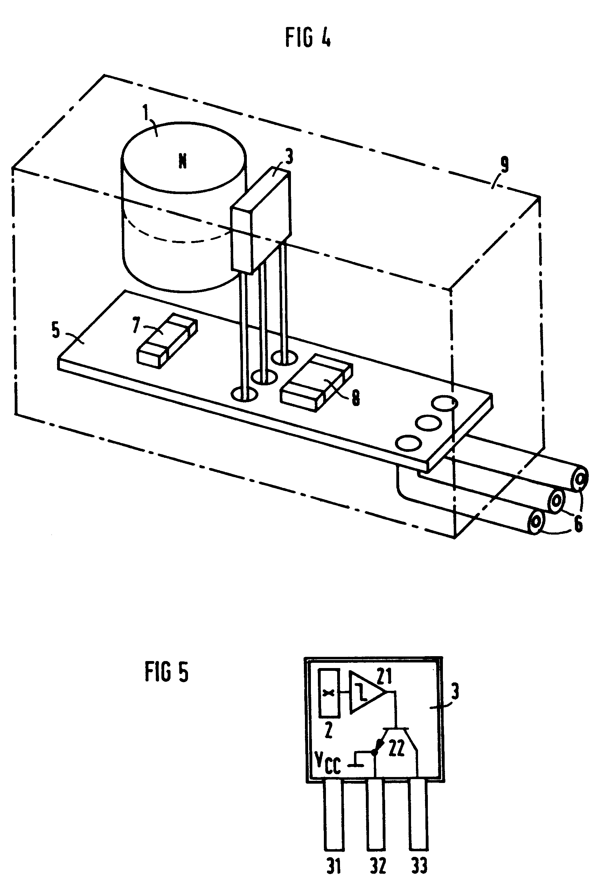

In Figur 4 ist grundsätzlich ein möglicher Aufbau für einen erfindungsgemäßen Näherungsschalter gezeigt. Auf einer Leiterplatte 5 mit Anschlußleitungen 6 ist der Magnetfeld-IC 3 mit dem bereits erwähnten Aufbau gemäß Figur 5 so angeordnet, daß der seitlich von dem Dauermagneten 1 in der Nähe von dessen neutraler Zone zu liegen kommt. Die Leiterplatte besitzt weitere Schaltungsbauteile, beispielsweise einen Widerstand 7 und einen Kondensator 8, die beispielsweise den Magnetfeld-IC gegen Überlastung schützen. Die Leiterplatte ist im übrigen in einem Gehäuse 9 untergebracht, das lediglich in seinen Umrissen angedeutet ist. Dieses Gehäuse besitzt natürlich eine nicht dargestellte Struktur zur Halterung der Leiterplatte und insbesondere auch zur Führung und Halterung des Dauermagneten 1. Zweckmäßigerweise ist dabei die Konstruktion so getroffen, daß der Dauermagnet 1 und der Magnetfeld-IC 3 relativ zueinander zur Justierung verschoben werden können. Beispielsweise wird der Dauermagnet 1 in einem Führungskanal kraftschlüssig gehalten, so daß er zur Justierung verschoben werden kann. Nach der Justierung kann beispielsweise der Dauermagnet bzw. der gesamte Aufbau in dem Gehäuse fixiert, etwa mit Gießharz vergossen, werden.

In Figur 6 ist eine weitere Ausführungsform eines Näherungsschalters beschrieben, bei dem im Vergleich zu Figur 1 ein zusätzlicher Magnetfeld-Sensor 13, und zwar dem Magnetfeld-Sensor 3 diametral gegenüberliegend an der Außenseite des Dauermagneten 1, angeordnet ist. Mit diesen zwei Magnetfeld-Sensoren kann die Annäherungsrichtung des Auslöseteiles 4 erkannt werden. In Figur 6 sind gestrichelt bzw. strichpunktiert die jeweiligen Schaltbereiche 10 und 11 der beiden Magnetfeld-Sensoren 3 und 13 angedeutet. D. h., wenn das Auslöseteil 4 bei Annäherung in Richtung s den Bereich 10 durchsetzt, spricht der erste Magnetfeld-Sensor 3 an; wenn das Auslöseteil 4 den Bereich 11 durchsetzt, spricht der zweite Magnetfeld-Sensor 13 an. Das von dem jeweiligen Magnetfeld-Sensor 3 bzw. 13 erzeugte digitale Ausgangssignal A3 bzw. A13 ist in Figur 7 aufgezeichnet. Man erkennt, daß bei einer Annäherung des Auslöseteiles 4 in Richtung s in Figur 6 zunächst das Ausgangssignal A3 des Magnetfeld-Sensors 3 den Pegel 1 erreicht, während das Ausgangssignal A13 diesen Pegel 1 erst später einnimmt. Entsprechend verläßt das Auslöseteil den Schaltbereich des Sensor 3 früher als den Schaltbereich des Sensors 13. Über ein geeignetes Logik-Bauelement, beispielsweise ein D-Flipflop, kann der Schaltimpuls des jeweils ersten Magnetfeld-Sensors gespeichert werden, um so die Annäherungsrichtung des Auslöseteiles anzuzeigen.

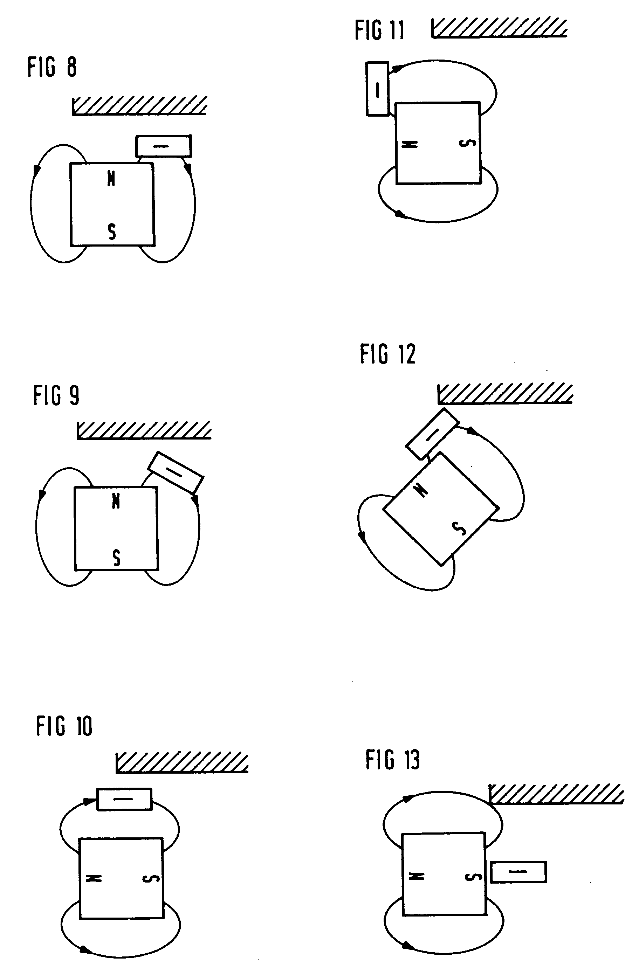

Weitere Ausführungsformen eines Näherungsschalters, bei denen der Magnetfeld-Sensor nicht in der Front zwischen zwei gegeneinander gerichteten Magnetfeldern, sondern parallel mit der Tangente der Magnetflußlinien angeordnet ist, sind in den Figuren 8, 9, 11 und 12 angedeutet. Bei diesem Anordnungsprinzip verziehen sich die Feldlinien durch asymmetrische Änderung durch das umliegende Medium mittels des Auslösekörpers und laufen dann nicht mehr mit dem Sensor parallel. Nur die entstehende senkrechte Magnetflußkomponente wird vom Sensor wahrgenommen und ausgewertet.

Im Gegensatz dazu ist der Magnetfeld-Sensor in Figur 10 in der neutralen Zone, jedoch gegenüber der Seite des Dauermagneten beabstandet, angeordnet. In Figur 13 ist der plättchenförmige Magnetfeld-Sensor in Axialrichtung von einem Pol wegstehend angeordnet, so daß ein Gleichgewicht zwischen den unter- wie oberhalb des Sensors vorbeifließenden Flußlinien besteht, das durch Annäherung an eine Seite des Magneten gestört wird. Die aktive Fläche, über die das Gleichgewicht der Magnetfelder gestört wird, befindet sich bei den Ausführungsbeispielen gemäß Figur 10 bis 13 nicht an der Polfläche, sondern seitlich am Magneten.

Die Anschlußfahnen des Magnetfeld-IC können auf verschiedene Weise, beispielsweise wie in FIG 4 dargestellt, durch das Gehäuse nach außen geführt und mit Anschlüssen des Schalters insgesamt verbunden sein. Diese Anschlüsse können jede beliebige Form haben, insbesondere können sie als an einer Leiterplatte oder Leiterstreifen angeordnete Schneidklemmanschlüsse (Crimpanschlüsse) ausgebildet sein, wie sie in der DE-PS 42 11 486 näher beschrieben sind.

**Patentansprüche**

1. Näherungsschalter mit einem Magnetfeld-Sensor (2) welcher in fester räumlicher Beziehung zu einem zweipoligen Dauermagneten (1) angeordnet und mit einer Schaltungseinrichtung (21, 22) verbunden ist, wobei durch Annäherung eines Auslösekörpers (4) an den Dauermagneten (1) die magnetische Induktion am Magnetfeld-Sensor (2) veränderbar und zu einer Änderung des Schaltungszustandes der Schaltungseinrichtung auswertbar ist, **dadurch gekennzeichnet,** daß der Magnetfeld-Sensor (2) seitlich nahe dem, insbesondere an dem Dauermagneten (1) in der Nähe der neutralen Zone (1a) zwischen beiden Polen des Dauermagneten positioniert ist und daß durch Annäherung eines ferromagnetischen Auslösekörpers (4) beziehungsweise durch Entfernung des Auslösekörpers (4) von dem Dauermagneten (1) jeweils eine zur Umschaltung der Schalteinrichtung (21, 22) auswertbare Änderung der magnetischen Induktion (B) an dem Magnetfeld-Sensor (2) erzeugt wird.

2. Näherungsschalter mit einem Magnetfeld-Sensor (2) welcher in fester räumlicher Beziehung zu einem zweipoligen Dauermagneten (1) angeordnet und mit einer Schaltungseinrichtung (21, 22) verbunden ist, wobei durch Annäherung eines Auslösekörpers (4) an den Dauermagneten (1) die magnetische Induktion am Magnetfeld-Sensor (2) veränderbar und zu einer Änderung des Schaltungszustandes der Schaltungseinrichtung auswertbar ist, **dadurch gekennzeichnet,** daß der Magnetfeld-Sensor (2) seitlich nahe dem, insbesondere an dem Dauermagneten (1) parallel zur Tangente der Flußlinien des Dauermagneten positioniert ist und daß durch Annäherung eines ferromagnetischen Auslösekörpers (4) beziehungsweise durch Entfernung des Auslösekörpers (4) von dem Dauermagneten (1) jeweils eine zur Umschaltung der Schalteinrichtung (21, 22) auswertbare Änderung der magnetischen Induktion (B) an dem Magnetfeld-Sensor (2) erzeugt wird.

3. Näherungsschalter nach Anspruch 1 oder 2, bei dem die Annäherung beziehungsweise Entfernung an einen der Pole (N) erfolgt.

4. Näherungsschalter nach Anspruch 1 oder 2, bei dem die Annäherung beziehungsweise Entfernung an eine zur Axialrichtung parallele Seite des Dauermagneten (1) erfolgt.

5. Näherungsschalter nach einem der Ansprüche 1 bis 4, **dadurch gekennzeichnet,** daß der Magnetfeld-Sensor (2) mit der Schalteinrichtung (21, 22) zu einem integrierten Schaltkreis (3) vereinigt ist.

6. Näherungsschalter nach einem der Ansprüche 1 oder 5, **dadurch gekennzeichnet,** daß der Dauermagnet (1) und der Magnetfeld-Sensor (2) in einem Gehäuse (9) relativ zueinander verschiebbar angeordnet und in justiertem Zustand fixierbar sind.

7. Näherungsschaltung nach einem der Ansprüche 1, 3 oder 4, **dadurch gekennzeichnet,** daß ein zweiter Magnetfeld-Sensor (13) den erstgenannten (3) diametral gegenüberliegend seitlich an dem Dauermagneten (1) angeordnet ist und daß in einer Auswerteschaltung aus der Zeitfolge der Signale von beiden Magnetfeld-Sensoren (3, 13) ein Richtungssignal für die Bewegung des Auslösekörpers (4) ableitbar ist.

8. Näherungsschalter nach einem der Ansprüche 1 bis 7, **dadurch gekennzeichnet,** daß als Magnetfeld-Sensor jeweils ein Hall-Sensor verwendet ist.

9. Näherungsschalter nach einem der Ansprüche 1 bis 7, **dadurch gekennzeichnet,** daß als Magnetfeldsensor ein Magnetoresistor verwendet ist.

10. Näherungsschalter nach einem der Ansprüche 1 bis 9, **dadurch gekennzeichnet,** daß die Anschlüsse des Schalters insgesamt als Schneidklemmanschlüsse ausgebildet sind.

FIG 1

FIG 2

## FIG 3

FIG 4

FIG 5

FIG 6

11 10

1

N

I I

13 3

S

S

4

FIG 7

A

1

A3

0 S

A

1

A13

0 S

FIG 8

FIG 11

FIG 9

FIG 12

FIG 10

FIG 13

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | WO-A-8 802 579 (GEBHARD BALUFF FABRIK GMBH) <br> * Seite 18, Zeile 1 - Seite 20, Zeile 10; Abbildungen 1,7 * <br> --- | 1-5,8 | H03K17/95 |
| X | DE-A-2 532 981 (SONY CORP.) <br> * Seite 5, Zeile 22 - Seite 6, Zeile 28 * <br> * Seite 19, Zeile 3 - Zeile 14 * <br> * Seite 20, Zeile 6 - Zeile 25; Abbildungen 12,14,14B * <br> --- | 1-5,9 | |
| A | DE-A-2 916 500 (ROBERT BOSCH GMBH) <br> * Seite 5, Zeile 7 - Seite 7, Zeile 6; Abbildungen 1,2 * <br> --- | 1 | |
| A | EP-A-0 283 291 (SPRAGUE ELECTRIC CO.) <br> * Seite 2, Zeile 28 - Zeile 42; Ansprüche 1-7; Abbildungen 1,8 * <br> --- | 7 | |
| A | US-A-4 603 295 (F. HEEMSTRA) <br> * Spalte 1, Zeile 50 - Spalte 2, Zeile 34; Abbildungen 1-3 * <br><br> ----- | 7 | **RECHERCHIERTE SACHGEBIETE (Int. Cl.5)** <br><br> H03K |

Der vorliegende Recherchenbericht wurde für alle Patentansprüche erstellt

| Recherchenort | Abschlußdatum der Recherche | Prüfer |
|---|---|---|
| DEN HAAG | 13 OKTOBER 1993 | BUTLER N.A. |